# EUROPEAN PATENT APPLICATION

(11) **EP 4 480 987 A1**
(43) Date of publication of application: **25.12.2024**
(21) Application number: 23756305.1
(22) Date of filing: 13.02.2023
(51) Int. Cl.: C08G 63/64, C08G 63/78, C08L 67/00

(54) **CURABLE RESIN PRODUCTION METHOD**

(30) Priority: 16.02.2022 JP 2022021962
(71) Applicant: MITSUBISHI GAS CHEMICAL COMPANY, INC., Chiyoda-ku Tokyo 100-8324 (JP)
(72) Inventor: KODA, Aiko, Hiratsuka-shi, Kanagawa 254-0016 (JP); YONEHAMA, Shinichi, Hiratsuka-shi, Kanagawa 254-0016 (JP)
(74) Representative: Müller-Boré & Partner Patentanwälte PartG mbB
(86) International application number: PCT/JP2023/004678
(87) International publication number: WO 2023/157780

(57) **Abstract**

The present invention provides a method for producing a curable resin, the method including: a step (A) of reacting a compound represented by Formula (2) and a compound represented by Formula (1) and/or a compound represented by Formula (1') in a molar equivalent smaller than the molar equivalent of the compound represented by Formula (2) by heating at normal pressure; and a step (B) of reacting a reaction product obtained by the step (A) and a compound represented by Formula (3) by heating at normal pressure.

## Description

### Technical Field

The present invention relates to a method for producing a curable resin, a curable resin obtained by the production method, a cured product thereof, and a resin composition.

### Background Art

Polyester carbonates are used in various applications because of excellent mechanical strength, thermal resistance, and transparency, and various polyester carbonates and production methods thereof have been reported.

For example, Patent Document 1 describes a polyester carbonate polyol having a norbornane backbone.

Patent Document 2 describes a polyester carbonate resin having a 1,1'-binaphthalene structure and a fluorene structure. Patent Document 2 describes that such a resin exhibits optically excellent performances.

Patent Document 3 describes a method for producing a polyester carbonate resin by reacting a reaction product containing a dihydroxy compound having a fluorene structure. Patent Document 3 describes that such a method for producing the resin can produce a resin having excellent fluidity and/or tensile strength.

### Citation List

### Patent Document

Patent Document 1: JP 05-105746 A
Patent Document 2: WO 2015/170691
Patent Document 3: WO 2017/078074

### Summary of Invention

### Technical Problem

Various polyester carbonates are known as described above; however, the polyester carbonates described above have poor miscibility with a curable resin, and addition to a curable resin is difficult. Furthermore, there is still room for improvement in characteristics of known polyester carbonates described above. An object of the present invention is to provide a curable resin and the like having a low dielectric loss tangent.

### Solution to Problem

As a result of diligent research, the present inventors discovered that a curable resin containing a predetermined structural unit excels in dielectric loss tangent, and thus completed the present invention.

The present invention includes the following embodiments:
[1] A method for producing a curable resin, the method including:
   a step (A) of reacting a compound represented by Formula (2) and a compound represented by Formula (1) and/or a compound represented by Formula (1') in a molar equivalent smaller than the molar equivalent of the compound represented by Formula (2) by heating at normal pressure; and
   a step (B) of reacting a reaction product obtained by the step (A) and a compound represented by Formula (3) by heating at normal pressure: 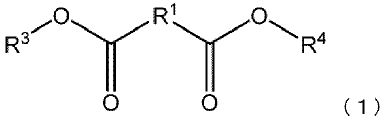 where in Formula (1), R¹ is a divalent group having an ethylenic double bond and/or an acetylene triple bond, and R³ and R⁴ are each independently a hydrogen atom or a monovalent hydrocarbon group having from 1 to 7 carbons; 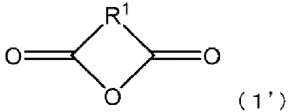 where in Formula (1'), R¹ is synonymous with R¹ in Formula (1); 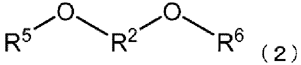 where in Formula (2), R² is any divalent group, and R⁵ and R⁶ are each independently a hydrogen atom or a monovalent hydrocarbon group having from 1 to 7 carbons; and 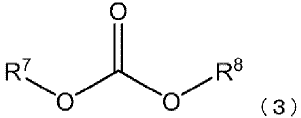
   where in Formula (3), R⁷ and R⁸ are each independently any substituent.
[2] The method for producing a curable resin according to [1] above, wherein in the step (A), a used amount of the compound represented by Formula (2) in terms of molar ratio with respect to a total used amount of the compound represented by Formula (1) and the compound represented by Formula (1') is 2 or greater and 100 or less.
[3] The method for producing a curable resin according to [1] or [2] above, wherein, after the compound represented by Formula (2) and the compound represented by Formula (1) and/or the compound represented by Formula (1') are reacted by heating at normal pressure, the step (A) further includes reacting under reduced pressure.
[4] The method for producing a curable resin according to any of [1] to [3] above, wherein a pressure reduction condition when applying reduced pressure in the step (A) is 100 kPa or less.
[5] The method for producing a curable resin according to any of [1] to [4] above, wherein a reaction temperature in the step (A) is from 80 to 290°C.
[6] The method for producing a curable resin according to any of [1] to [5] above, wherein, after the reaction product obtained by the step (A) and the compound represented by Formula (3) are reacted by heating at normal pressure, the step (B) further includes reacting under reduced pressure.
[7] The method for producing a curable resin according to any of [1] to [6] above, wherein a pressure reduction condition when applying reduced pressure in the step (B) is 10 kPa or less.
[8] The method for producing a curable resin according to any of [1] to [7] above, wherein, in the step (B), a used amount of the compound represented by Formula (3) is an amount greater than a number of moles obtained by subtracting a total used amount of the compound represented by Formula (1) and/or the compound represented by Formula (1') from a used amount of the compound represented by Formula (2).
[9] The method for producing a curable resin according to any of [1] to [8] above, wherein a reaction temperature in the step (B) is from 100 to 290°C.
[10] The method for producing a curable resin according to any one of [1] to [9] above, wherein the compound represented by Formula (1) and the compound represented by Formula (1') are at least one selected from the group consisting of fumaric acid, maleic acid, and maleic anhydride.
[11] The method for producing a curable resin according to any of [1] to [10] above, wherein R² in Formula (2) is a divalent group having an alicyclic structure in a main chain or a side chain.
[12] The method for producing a curable resin according to any of [1] to [11] above, wherein the compound represented by Formula (2) contains at least one selected from the group consisting of a norbornane-based backbone and a cyclohexane-based backbone.
[13] The method for producing a curable resin according to any of [1] to [12] above, wherein the compound represented by Formula (3) is at least one selected from the group consisting of a dialkyl carbonate, a diaryl carbonate, and an alkyl aryl carbonate.
[14] The method for producing a curable resin according to any of [1] to [13] above, wherein a functional group equivalent of a terminal OH group of the curable resin is 500 g/eq or greater.
[15] The method for producing a curable resin according to any of [1] to [14] above, wherein a number average molecular weight of the curable resin is 5.00 × 10² or greater and 3.00 × 10⁴ or less.
[16] A curable resin produced by the production method according to any of [1] to [15] above.
[17] A resin composition containing the curable resin according to [16] above.
[18] A cured product of the curable resin according to [16] above or the resin composition according to [17] above.
[19] The resin composition according to [17] above, which is for an electronic material.
[20] An electronic member containing the resin composition according to [17] above.
[21] A fiber-reinforced composite material containing the resin composition according to [20] above and a reinforcing fiber.
[22] A fiber-reinforced molded article, which is a cured product of the fiber-reinforced composite material according to [21] above.
[23] A semiconductor sealing material containing the resin composition according to [17] above and an inorganic filler.
[24] A semiconductor device including a cured product of the semiconductor sealing material according to [23] above.
[25] A prepreg, including a substrate, and the resin composition according to [17] above with which the substrate is impregnated or coated.
[26] A laminate, including the prepreg according to [25] above.
[27] A circuit board, including the laminate according to [26] above, and a metal foil provided on one face or both faces of the laminate.
[28] A build-up film, including a cured product of the resin composition according to [17] above and a substrate film.

### Advantageous Effects of Invention

The present invention can provide a curable resin and the like having a low dielectric loss tangent.

### Description of Embodiments

Hereinafter, embodiments of the present invention (hereinafter, referred to as "the present embodiment") will be described in detail; however, the present invention is not limited to these embodiments, and various modifications may be made without departing from the scope and spirit of the invention.

In the present description, a bond cut by a wavy line in a chemical structural formula means a bonding position of the structural unit represented by the chemical structural formula for another structural unit.

### [Method for Producing Curable Resin]

An embodiment of the present invention relates to a method for producing a curable resin.

The method for producing a curable resin of the present embodiment includes:
a step (A) of reacting a compound represented by Formula (2) below and a compound represented by Formula (1) below and/or a compound represented by Formula (1') below in a molar equivalent smaller than the molar equivalent of the compound represented by Formula (2) below by heating at normal pressure; and
a step (B) of reacting a reaction product obtained by the step (A) and a compound represented by Formula (3) below by heating at normal pressure: 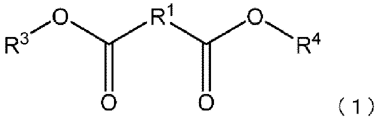 where in Formula (1), R¹ is a divalent group having an ethylenic double bond and/or an acetylene triple bond, and R³ and R⁴ are each independently a hydrogen atom or a monovalent hydrocarbon group having from 1 to 7 carbons; 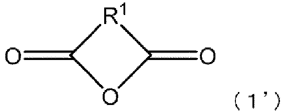 where in Formula (1'), R¹ is synonymous with R¹ in Formula (1); 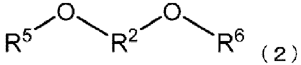 where in Formula (2), R² is any divalent group, and R⁵ and R⁶ are each independently a hydrogen atom or a monovalent hydrocarbon group having from 1 to 7 carbons; and 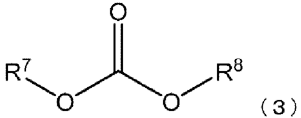 where in Formula (3), R⁷ and R⁸ are each independently any substituent.

In the present embodiment, the compound represented by Formula (1) is also referred to as a "dicarboxylic acid compound", the compound represented by Formula (1') is also referred to as a "dicarboxylic anhydride", the compound represented by Formula (2) is also referred to as a "dihydroxy compound", and the compound represented by Formula (3) is also referred to as a "carbonate compound".

The curable resin obtained by the production method of the present embodiment can reduce the amount of terminal hydroxy group compared to a case of a curable resin obtained by a known method, and as a result, excellent dielectric properties can be imparted to the curable resin.

Note that, in Formula (1) above, R¹ is a divalent group having an ethylenic double bond and/or an acetylene triple bond, and R³ and R⁴ are each independently a hydrogen atom or a monovalent hydrocarbon group having from 1 to 7 carbons. In Formula (1') above, R¹ is synonymous with R¹ in Formula (1). In Formula (2) above, R² is any divalent group, and R⁵ and R⁶ are each independently a hydrogen atom or a monovalent hydrocarbon group having from 1 to 7 carbons. In Formula (3) above, R⁷ and R⁸ are each independently any substituent.

In the method for producing a curable resin of the present embodiment, a dicarboxylic acid unit of the curable resin of the present embodiment is formed by reaction and incorporation of the dicarboxylic acid compound or the dicarboxylic anhydride into the resin. Similarly, a dihydroxy unit and a carbonate unit of the curable resin of the present embodiment are formed respectively by reaction and incorporation of the dihydroxy compound and the carbonate compound into the resin. That is, in the curable resin of the present embodiment, the dicarboxylic acid unit is a structural unit derived from the dicarboxylic acid compound or the dicarboxylic anhydride, the dihydroxy unit is a structural unit derived from the dihydroxy compound, and the carbonate unit is a structural unit derived from the carbonate compound.

R¹ in the dicarboxylic acid compound or the dicarboxylic anhydride is a divalent group having an ethylenic double bond and/or an acetylene triple bond. In the present description, the term "ethylenic double bond" means a carbon-carbon double bond that does not form an aromatic ring. Furthermore, the term "acetylene triple bond" means a carbon-carbon triple bond. Since the curable resin of the present embodiment has an unsaturated bond between carbons, which is not forming an aromatic ring as described above, the curable resin can crosslink independently or by a crosslinking agent.

The number of carbons in R¹ is not particularly limited and, for example, is 2 or greater and 8 or less, preferably 2 or greater and 6 or less, more preferably 2 or greater and 4 or less, and even more preferably 2 or greater and 3 or less.

The total number of the ethylenic double bond and the acetylene triple bond in R¹ is not particularly limited as long as the total number is 1 or greater and, for example, is 1 or greater and 3 or less, preferably 1 or greater and 2 or less, and more preferably 1. R¹ preferably contains an ethylenic double bond.

Examples of a preferred aspect of R¹ include a divalent hydrocarbon group having one ethylenic double bond and having 2 or more and 4 or less carbons. In this preferred aspect, the number of ethylenic double bonds and the number of carbons may be freely changed within the ranges described above.

As the dicarboxylic acid compound or dicarboxylic anhydride, at least one selected from the group consisting of fumaric acid, maleic acid, and maleic anhydride is preferred. In this case, R¹ in Formula (1) above is a divalent hydrocarbon group having an ethylenic double bond and having 2 carbons. According to such an aspect, the dielectric properties of the resulting curable resin tends to be even better.

In the method for producing a curable resin of the present embodiment, one type of the dicarboxylic acid compound or dicarboxylic anhydride may be used, or two or more types of the dicarboxylic acid compounds and/or dicarboxylic anhydrides may be used. From the viewpoint of ease in production, and from the viewpoint of ease in controlling properties of the resulting resin, using one type of the dicarboxylic acid compound or dicarboxylic anhydride is preferable.

R² in the dihydroxy compound is preferably any divalent group and having an alicyclic structure in a main chain or a side chain. Because R² is a divalent group having an alicyclic structure in a main chain or a side chain, it is presumed that the main chain of the curable resin of the present embodiment becomes rigid, and a molar volume becomes greater. As a result, it is presumed that motion of a molecular chain of the entire resin molecule is limited, and the dielectric properties are improved. However, the factor thereof is not limited to this. R² preferably has an alicyclic structure in a main chain. Furthermore, R² may have two or more alicyclic structures.

The number of carbons in R² is not particularly limited and, for example, is 5 or greater and 100 or less, preferably 6 or greater and 20 or less, more preferably 7 or greater and 18 or less, and even more preferably 8 or greater and 17 or less. The number of carbons in R² may be 80 or less, 70 or less, 60 or less, 50 or less, 40 or less, or 30 or less, but within the range described above.

In a case where R² is a divalent group having an alicyclic structure in a main chain or a side chain, the proportion of the number of carbon atoms constituting the alicyclic structure with respect to the number of carbon atoms contained in R² is not particularly limited and, for example, is 50% or greater and 100% or less. The proportion is preferably 60% or greater, more preferably 70% or greater, and even more preferably 75% or greater, within the range described above. According to such an aspect, motion of a molecular chain in the dihydroxy unit is further limited, and the dielectric properties of the curable resin are further improved. The upper limit value of the proportion is not particularly limited and, for example, may be 100%, 95%, 90%, or 85%.

R² may be a divalent saturated hydrocarbon group or may be a divalent unsaturated hydrocarbon group.

The dihydroxy compound preferably contains at least one selected from the group consisting of a cycloalkane backbone or a norbornane-based backbone and a cyclohexane-based backbone. According to such an aspect, the dielectric properties of the resulting curable resin tends to be further improved. In the present description, the term "norbornane-based backbone" means a backbone selected from the group consisting of a backbone containing norbornane (bicyclo[2.2.1]heptane) and a backbone in which a single bond in this backbone is replaced with an unsaturated bond. Thus, the norbornane-based backbone includes, for example, a norbornane backbone and a norbornene backbone.

The carbonate compound is preferably at least one selected from the group consisting of a dialkyl carbonate, a diaryl carbonate, and an alkyl aryl carbonate. Specific examples of the dialkyl carbonate, the diaryl carbonate, and the alkyl aryl carbonate will be described below.

R³, R⁴, R⁵, and R⁶ in the dicarboxylic acid compound and the dihydroxy compound are each independently a hydrogen atom or a monovalent hydrocarbon group having from 1 to 7 carbons. When the dicarboxylic acid compound or the dihydroxy compound reacts and is incorporated into the resin, the reaction progresses as R³-OH, R⁴-OH, R⁵-OH, and R⁶-OH corresponding to R³, R⁴, R⁵, and R⁶ are eliminated. Thus, R³, R⁴, R⁵, and R⁶ are each preferably a group having a high stability of the hydroxide compound. Furthermore, from the viewpoint of enhancing reactivity, R³, R⁴, R⁵, and R⁶ are preferably each a group having small steric hindrance.

The above R³, R⁴, R⁵, and R⁶ are preferably each independently a hydrogen atom, a methyl group, an ethyl group, an n-propyl group, an isopropyl group, an n-butyl group, an isobutyl group, a phenyl group, or a benzyl group, more preferably a hydrogen atom, a methyl group, an ethyl group, or a phenyl group, even more preferably a hydrogen atom or a methyl group, and particularly preferably a hydrogen atom.

In a preferred aspect of the method for producing a curable resin of the present embodiment, a dicarboxylic anhydride is used, and a dihydroxy compound, in which R⁵ and R⁶ are each a hydrogen atom, is used. In another preferred aspect of the method for producing a curable resin of the present embodiment, a dicarboxylic acid compound, in which R³ and R⁴ are each a hydrogen atom, or a dihydroxy compound, in which R⁵ and R⁶ are each a hydrogen atom, is used. According to such an aspect, the curable resin tends to be efficiently produced.

In the carbonate compound, R⁷ and R⁸ are each independently any substituent. When the carbonate compound reacts and is incorporated into the resin, the reaction progresses as R⁷-OH and R⁸-OH corresponding to R⁷ and R⁸ are eliminated. Thus, R⁷ and R⁸ are each preferably a group having a high stability of the hydroxide compound. Furthermore, R⁷ and R⁸ are preferably selected in a manner that the carbonate compound becomes a stable compound.

The above R⁷ and R⁸ are preferably alkyl groups or aryl groups, more preferably alkyl groups having from 1 to 6 carbons or aryl groups having from 6 to 12 carbons, even more preferably alkyl groups having from 1 to 3 carbons or aryl groups having 6 carbons (phenyl groups), and yet even more preferably phenyl groups.

The carbonate compound is not particularly limited and examples thereof include diphenyl carbonate, ditolyl carbonate, dimethyl carbonate, diethyl carbonate, di-t-butyl carbonate, bis(chlorophenyl)carbonate, m-cresyl carbonate, and dicyclohexyl carbonate. The carbonate compound is preferably diphenyl carbonate and/or an alkyl group-substituted diphenyl carbonate.

The dicarboxylic acid compound, the dicarboxylic anhydride, the dihydroxy compound, and the carbonate compound may be used alone, or may be used in a combination of two or more.

In the method for producing a curable resin of the present embodiment, a monomer or an oligomer or a polymer other than the dicarboxylic acid compound represented by Formula (1), the dicarboxylic anhydride represented by Formula (1'), the dihydroxy compound represented by Formula (2), and the carbonate compound represented by Formula (3) may be added into the reaction system allowing them to be incorporated into the curable resin. Examples of such a compound include a dicarboxylic acid compound and anhydride thereof other than the dicarboxylic acid compound represented by Formula (1), a dihydroxy compound other than the dihydroxy compound represented by Formula (2), a monohydroxy compound having an ethylenic double bond, a silicone oil having a hydroxy group in a molecular structure, and a silicone oil having a carboxy group in a molecular structure. Examples of the compound include those described for explanation of the curable resin of the present embodiment, and one of such a compound may be used alone, or a combination of two or more of such compounds may be used.

In the step (A), the total used amount of the dicarboxylic acid compound and/or the dicarboxylic anhydride is an amount smaller than the used amount of the dihydroxy compound in terms of moles. According to such an aspect, a polyol compound tends to be formed in the step (A) and tends to suitably react with a carbonate compound in the step (B). The used amount of the dihydroxy compound in terms of molar ratio with respect to the total used amount of the dicarboxylic acid compound and the dicarboxylic anhydride is preferably 2 or greater and 100 or less, more preferably 3 or greater and 70 or less, even more preferably 3 or greater and 50 or less, and yet even more preferably 3 or greater and 30 or less.

The reaction in the step (A) is performed by heating the reaction product at normal pressure. The reaction temperature in the step (A) is not particularly limited as long as it is a temperature increase condition and, for example, is from 80 to 290°C (including the lowest and highest numbers, the same applies in the present description unless otherwise noted) and is preferably from 120 to 270°C, and more preferably from 150 to 250°C.

The reaction in the step (A) may be performed by heating the reaction product at normal pressure and then may further be performed by heating under reduced pressure. In a case where the reaction under reduced pressure is performed in the step (A), the pressure in the system is not particularly limited as long as it is a reduced pressure condition and, for example, is 100 kPa or less, preferably 50 kPa or less, and more preferably 30 kPa or less.

In the step (B), the reaction product obtained in the step (A) and a carbonate compound are reacted by heating at normal pressure. In the step (B), the used amount of the carbonate compound in terms of moles is preferably greater than the number of moles obtained by subtracting the total used amount of the dicarboxylic acid compound and the dicarboxylic anhydride from the used amount of the dihydroxy compound. According to such an aspect, because the larger amount of the carbonate compound than the number of hydroxy moieties of the reaction product obtained in the step (A) is used, the amount of terminal hydroxy groups of the resulting curable resin can be reduced. By this, a curable resin having even better dielectric properties tends to be obtained.

The reaction in the step (B) is performed by heating the reaction product at normal pressure. The reaction temperature (final temperature) in the step (B) is not particularly limited as long as it is a temperature increase condition and, for example, is from 100 to 290°C, preferably from 130 to 280°C, and more preferably from 160 to 260°C.

The reaction in the step (B) may be performed by heating the reaction product at normal pressure and then may further be performed by heating under reduced pressure. The reaction in the step (B) may be performed by gradually increasing the temperature and reducing the pressure to finally maintain under increased temperature and reduced pressure. In a case where the reaction under reduced pressure is performed in the step (B), the pressure in the system is not particularly limited as long as it is a reduced pressure condition and, for example, is 10 kPa or less, preferably 5 kPa or less, and more preferably 1 kPa or less.

The step (A) and the step (B) are preferably performed in the presence of an inert gas. Examples of the inert gas include a nitrogen gas and an argon gas.

In each of the step (A) and the step (B), in a case where the reaction product is a solid, each of the reaction products may be supplied as a solid, may be supplied in a molten state by heating, or may be supplied as an aqueous solution. In a case where the reaction product is a liquid, the reaction product may be supplied as a single liquid or may be supplied as a mixture with a solvent. Furthermore, the form of the reaction may be in any method selected from a batchwise form, a continuous form, or a combination of batchwise and continuous forms.

The step (A) and the step (B) are preferably performed in the presence of a catalyst. Examples of the catalyst include a catalyst that is typically used for synthesis of polycarbonate or synthesis of polyester. Specific examples thereof include an alkali metal compound, an alkaline earth metal compound, a nitrogen-containing compound, and salts of titanium, tin, zinc, zirconium, and/or lead. Furthermore, a basic compound such as a basic boron compound or a basic phosphorus compound may be used supplementarily and together with the alkali metal compound and/or the alkaline earth metal compound.

Examples of the alkali metal compound include organic acid salts, inorganic salts, oxides, hydroxides, hydrides, and alkoxides of alkali metals. Specific examples thereof include sodium hydroxide, potassium hydroxide, lithium hydroxide, cesium hydroxide, sodium hydrogencarbonate, potassium hydrogencarbonate, lithium hydrogencarbonate, cesium hydrogencarbonate, sodium carbonate, potassium carbonate, lithium carbonate, cesium carbonate, sodium acetate, potassium acetate, lithium acetate, cesium acetate, sodium stearate, potassium stearate, lithium stearate, cesium stearate, sodium borohydride, potassium borohydride, lithium borohydride, cesium borohydride, sodium phenylborate, potassium phenylborate, lithium phenylborate, cesium phenylborate, sodium benzoate, potassium benzoate, lithium benzoate, cesium benzoate, disodium hydrogenphosphate, dipotassium hydrogenphosphate, dilithium hydrogenphosphate, dicesium hydrogenphosphate, disodium phenyl phosphate, dipotassium phenyl phosphate, dilithium phenyl phosphate, dicesium phenyl phosphate, alcoholates and phenolates of sodium, potassium, lithium, and cesium, and disodium salts, dipotassium salts, dilithium salts, and dicesium salts of bisphenol A.

Examples of the alkaline earth metal compound include organic acid salts, inorganic salts, oxides, hydroxides, hydrides, and alkoxides of alkaline earth metal compounds. Specific examples thereof include calcium hydroxide, barium hydroxide, magnesium hydroxide, strontium hydroxide, calcium hydrogencarbonate, barium hydrogencarbonate, magnesium hydrogencarbonate, strontium hydrogencarbonate, calcium carbonate, barium carbonate, magnesium carbonate, strontium carbonate, calcium acetate, barium acetate, magnesium acetate, strontium acetate, calcium stearate, barium stearate, magnesium stearate, and strontium stearate.

Examples of the nitrogen-containing compound include quaternary ammonium hydroxides and salts thereof and amines. Specific examples thereof include quaternary ammonium hydroxides containing an alkyl group and/or an aryl group such as tetramethylammonium hydroxide, tetraethylammonium hydroxide, tetrapropylammonium hydroxide, tetrabutylammonium hydroxide, and trimethylbenzylammonium hydroxide; tertiary amines such as triethylamine, dimethylbenzylamine, and triphenylamine; secondary amines such as diethylamine and dibutylamine; primary amines such as propylamine and butylamine; imidazoles such as 2-methylimidazole, 2-phenylimidazole, and benzimidazole; and base or basic salts such as ammonia, tetramethylammonium borohydride, tetrabutylammonium borohydride, tetrabutylammonium tetraphenylborate, and tetraphenylammonium tetraphenylborate.

Examples of the titanium salt include tetramethyl titanate, tetrabutyl titanate, tetrapropyl titanate, tetraisopropyl titanate, tetraisobutyl titanate, and tetraphenyl titanate.

Examples of the tin salt include tin(II) chloride, tin(IV) chloride, tin(II) acetate, tin(IV) acetate, dibutyltin oxide, dibutyltin dilaurate, dibutyltin dimethoxide, and dibutyltin diacetate.

Examples of the zinc salt include zinc acetate, zinc benzoate, and zinc 2-ethylhexanoate.

Examples of the zirconium salt include zirconium acetylacetonate, zirconium oxyacetate, and zirconium tetrabutoxide.

Examples of the lead salt include lead(II) acetate and lead(IV) acetate.

Furthermore, examples of the basic boron compound that can be used together with the alkali metal compound and/or the alkaline earth metal compound include sodium salts, potassium salts, lithium salts, calcium salts, barium salts, magnesium salts, and strontium salts and the like of tetramethylboron, tetraethylboron, tetrapropylboron, tetrabutylboron, trimethylethylboron, trimethylbenzylboron, trimethylphenylboron, triethylmethylboron, triethylbenzylboron, triethylphenylboron, tributylbenzylboron, tributylphenylboron, tetraphenylboron, benzyltriphenylboron, methyltriphenylboron, and butyltriphenylboron.

Examples of the basic phosphorus compound include triethylphosphine, tri-n-propylphosphine, triisopropylphosphine, tri-n-butylphosphine, triphenylphosphine, tributylphosphine, and quaternary phosphonium salts.

In addition, examples of the catalyst typically used for synthesis of polycarbonate or synthesis of polyester include an antimony compound such as diantimony trioxide; a germanium compound such as germanium dioxide and germanium tetroxide; a manganese compound; and catalysts described in US Patent Nos. 4,025,492, 4,136,089, 4,176,224, 4,238,593, and 4,208,527, and R.E.Wilfong, Journal of Polymer Science, 54, 385, (1961).

One of these catalysts may be used alone, or two or more of these catalysts may be used in combination. In the production method of the present embodiment, a titanium salt catalyst is preferably used.

Note that, in the embodiment using the catalyst, the catalyst needs to be added in the step (A), and a new catalyst does not need to be necessarily added in the step (B). Alternatively, the reaction in the presence of the catalyst may be performed in a part of the steps among the steps of the production method of the present embodiment.

The used amount of the catalyst is not particularly limited and, for example, is, in terms of metal atom, from 0.1 to 500 µmol, and preferably from 0.5 to 100 µmol, with respect to 1 mol of all the dihydroxy compounds used in the reaction.

In at least one of the step (A) or (B), a compound described above other than the dicarboxylic acid compound represented by Formula (1), the dicarboxylic anhydride represented by Formula (1'), the dihydroxy compound represented by Formula (2), and the carbonate compound represented by Formula (3) may be added to the reaction system and may be reacted together with the dicarboxylic acid compound, the dicarboxylic anhydride, the dihydroxy compound, and/or the carbonate compound.

The method for producing a curable resin of the present embodiment may include another step, other than the steps (A) and (B), which is to simply react the compound described above other than the dicarboxylic acid compound represented by Formula (1), the dicarboxylic anhydride represented by Formula (1'), the dihydroxy compound represented by Formula (2), and the carbonate compound represented by Formula (3).

The production method of the curable resin of the present embodiment may include a step of purifying a resulting product after reacting the dicarboxylic acid compound and/or the dicarboxylic anhydride, the dihydroxy compound, and the carbonate compound as described above. The purification step may be a step of removing an unreacted reaction product incorporated into the curable resin, byproducts, and/or the catalyst component. Examples of the byproducts include compounds formed by a condensation reaction of the dicarboxylic anhydride, the dihydroxy compound, and the carbonate compound.

As the purification step, a method that is typically used as a purification method of a resin may be appropriately used. Specific examples thereof include a reprecipitation method in which dropwise addition is performed in a poor solvent or water after the resin is dissolved in a solvent, and a liquid-liquid extraction method. As the purification step, liquid-liquid extraction using toluene and a sodium carbonate aqueous solution is preferably used. Because such a method uses toluene having a low dielectric constant as an oil phase, after the purification, a curable resin having even better dielectric properties tends to be obtained. Such a purification step may be performed in the middle of steps (e.g., in between the steps (A) and (B)).

As the purification step, a method that is typically used as a purification method of a resin may be appropriately used, and preferably liquid-liquid extraction using toluene as an oil phase is preferably used. More specifically, liquid-liquid extraction using toluene and a sodium carbonate aqueous solution may be used. Because such a method uses toluene having a low dielectric constant as an oil phase, after the purification, a curable resin having even better dielectric properties tends to be obtained.

For the method for producing a curable resin of the present embodiment, "Polyester Resin Handbook" (written by Eiichiro Takiyama, published by The Nikkan Kogyo Shimbun) may be appropriately considered.

In addition to the production method described above, the curable resin of the present embodiment may be produced by a method in which at least one of the dicarboxylic acid compound or the dicarboxylic anhydride is reacted with a polycarbonate diol. The polycarbonate diol to be used is not particularly limited as long as the polycarbonate diol is a compound having a carbonate bond and having hydroxy groups at both terminals, and examples thereof include a known commercially available polycarbonate diol. The reaction conditions and the catalyst that may be used are the same as those for the step (B) described above.

Furthermore, in the production method including the steps (A) and (B) and the production method including the steps (A) and (B), a polycarbonate diol may be used in place of the dihydroxy compound represented by Formula (2). The polycarbonate diol to be used is not particularly limited as long as the polycarbonate diol is a compound having a carbonate bond and having hydroxy groups at both terminals, and examples thereof include a known commercially available polycarbonate diol. According to such an aspect, a curable resin containing a large amount of carbonate units tends to be obtained.

The method for producing a curable resin of the present embodiment includes all aspects of the method for producing a curable resin obtained by freely combining all aspects described above.

### [Curable Resin]

The curable resin of the present embodiment contains
a structural unit represented by Formula (4) below (hereinafter, also referred to as a "dicarboxylic acid unit"): 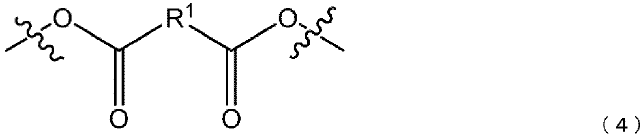
a structural unit represented by Formula (5) below (hereinafter, also referred to as a "dihydroxy unit"): 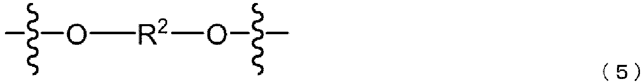
and a structural unit represented by Formula (6) below (hereinafter, also referred to as a "carbonate unit"):

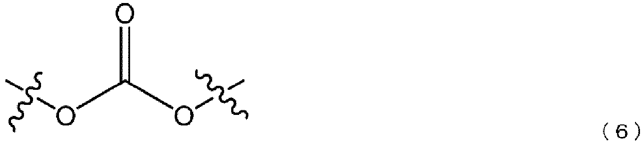

R¹ in Formula (4) above and R² in Formula (5) above are respectively synonymous with R¹ in Formula (1) and Formula (1') above and R² in Formula (2) above, and preferred aspects thereof are also as described above.

Because the curable resin of the present embodiment has an ethylenic double bond and/or an acetylene triple bond in the dicarboxylic acid unit, crosslink can be formed within a molecule or in between molecules, and thus curing can be performed by an appropriate method. Since a known polyester carbonate does not have points (functional groups) that can crosslink with the curable resin, when such a known polyester carbonate is added to a curable resin having a low miscibility, problems such as occurrence of phase separation or release at an interface between the curable resin and the polyester carbonate occur. Since the curable resin of the present embodiment contains the ethylenic double bond and/or the acetylene triple bond although the curable resin is a resin containing an ester bond and a carbonate bond, in a case where the curable resin is mixed with another curable resin, the curable resin can react with a functional group of such another curable resin to crosslink. Because of this, the curable resin of the present embodiment can be cured alone, and is less likely to cause phase separation or interfacial delamination even in a case where the curable resin is mixed with another curable resin.

Furthermore, it is presumed that the curable resin of the present embodiment exhibits excellent dielectric properties and achieves a low dielectric constant and dielectric loss tangent due to the dihydroxy unit having an alicyclic structure. It is presumed that this is because the molar volume of the dihydroxy unit is large and motion of molecular chains of the resin molecule is restricted by the alicyclic structure; however, the factors thereof are not limited to these.

Note that, in the present description, excellent in dielectric properties means that both dielectric constant and dielectric loss tangent are low. Specific values of the dielectric constant and the dielectric loss tangent are not particularly limited and, for example, in a case where the dielectric constant (relative dielectric constant) of a cured product of the curable resin or the resin composition produced as described in Examples is 2.7 or less and the dielectric loss tangent is 0.010 or less, and preferably 0.006 or less, it can be said that the dielectric properties are excellent. The curable resin and the resin composition of the present embodiment each have a low dielectric constant and a low dielectric loss tangent when formed into a cured product.

The dielectric constant and the dielectric loss tangent that are measured in the same manner as described in Examples below of the cured product of the curable resin or the resin composition of the present embodiment are respectively preferably 2.7 or less and 0.010 or less, and more preferably 2.7 or less and 0.006 or less.

The curable resin of the present embodiment is a resin that cures in response to appropriate stimulus or voluntarily. In one aspect, the curable resin of the present embodiment is a thermosetting resin, and in another aspect, the curable resin is a photocurable resin.

The isomeric structure in a case where the dicarboxylic acid unit has an ethylenic double bond is not particularly limited. That is, the dicarboxylic acid unit having the ethylenic double bond may have a cis configuration or may have a trans configuration. From the viewpoint of further improving the dielectric properties of the curable resin or from the viewpoint of further improving mechanical properties, the dicarboxylic acid unit having the ethylenic double bond preferably has a cis configuration.

The dicarboxylic acid unit represented by Formula (4) above is preferably a structural unit represented by Formula (4-1) or (4-2) below, and is more preferably a structural unit represented by Formula (4-1) below: 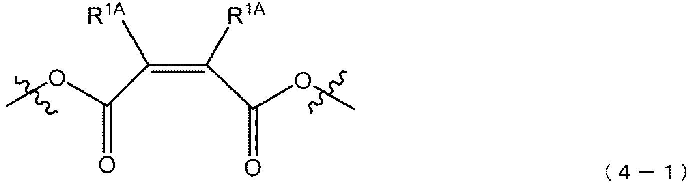 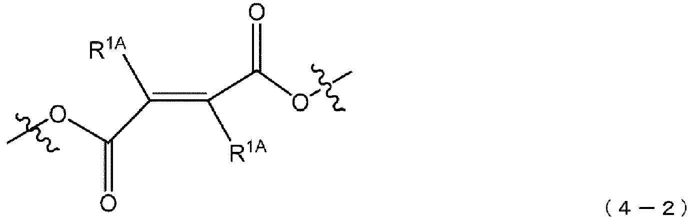 Note that, in Formulas (4-1) and (4-2) above, R^{1A} is each independently a hydrogen atom, a methyl group, or an ethyl group. R^{1A} is, each independently, preferably a hydrogen atom or a methyl group.

The dicarboxylic acid unit is particularly preferably a structural unit derived from maleic acid or maleic anhydride. In this case, R¹ in Formula (1) above is a divalent hydrocarbon group having an ethylenic double bond and having 2 carbons, and the dicarboxylic acid unit has a cis configuration. According to such an aspect, the dielectric properties of the curable resin tend to be even better.

The curable resin of the present embodiment may only contain one type of dicarboxylic acid unit or may contain two or more types of dicarboxylic acid units. From the viewpoint of ease in production and from the viewpoint of ease in controlling properties of the resin, containing one type of the dicarboxylic acid unit in the curable resin is preferable.

The dihydroxy unit is preferably a structural unit derived from a dihydroxy compound containing a norbornane-based backbone, and is more preferably a structural unit derived from a dihydroxy compound containing a norbornane backbone. According to such an aspect, the dielectric properties of the curable resin tend to be further improved.

An example of another preferred aspect is an aspect in which the dihydroxy unit contains a cyclohexane ring.

The dihydroxy unit represented by Formula (5) above is preferably a structural unit represented by Formula (5-4) below, and is preferably a structural unit represented by Formula (5-1), (5-2), or (5-3) below. Alternatively, the dihydroxy unit may be a structural unit in which R^{2A} and/or R^{2B} and/or R^{2C} and/or R^{2D} are repeated in between terminal oxygen atoms.

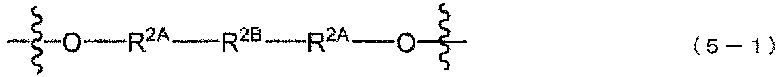

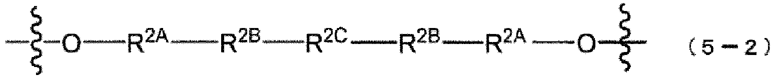

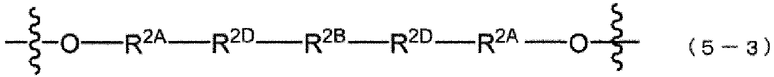

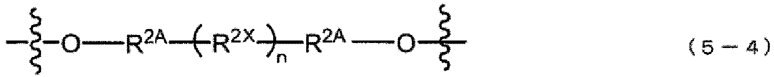

Note that, in the formulas above, R^{2A} is each independently a single bond, a methylene group, or an ethylene group; R^{2B} is a divalent alicyclic structure that may have an alkyl group having 5 or more and 30 or less carbons, 5 or more or 20 or less carbons, or 5 or more and 15 or less carbons; R^{2C} is each independently a single bond or a methylene group or ethylene group that may have at least one methyl group or ethyl group, R^{2D} is each independently a divalent aryl group, R^{2X} is each independently R^{2A}, R^{2B}, R^{2C}, or R^{2D}, and n is an integer of 1 or greater and 6 or less. However, in Formula (2-4), at least one of n pieces of R^{2X} is R^{2B}.

In the formula above, R^{2A} is each independently preferably a single bond or a methylene group.

In the formula above, R^{2B} may be a monocyclo ring, a bicyclo ring, a tricyclo ring, or a polycyclo ring, which may have an alkyl group. R^{2B} preferably contains a cyclohexane ring and/or a norbornane-based backbone, more preferably contains a norbornane backbone, and even more preferably contains a decahydro-1,4:5,8-dimethanonaphthalene backbone represented by Formula (7) below. In a case where R^{2B} contains a cyclohexane ring, a norbornane-based backbone, a norbornane backbone, and/or a decahydro-1,4:5,8-dimethanonaphthalene backbone, a group bonded to R^{2B} may bond to any moiety in the backbone or the ring, and may be bonded to another cyclo ring that bonds to the backbone.

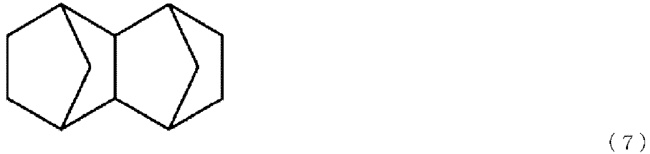

The alkyl group that may be contained in R^{2B} is not particularly limited but is preferably a methyl group or an ethyl group. R^{2B} may be a divalent alicyclic structure having no alkyl group. The alicyclic structure of R^{2B} may contain 0 or more and 6 or less, 0 or more and 4 or less, 0 or more and 3 or less, 0 or more and 2 or less, or 0 or more and 1 or less alkyl group(s).

In the formula above, the methylene group or ethylene group that may have at least one of a methyl group or an ethyl group of R^{2C} include a methylene group, an ethylene group, a methylmethylene group, an ethylmethylene group, a methylethylene group, an ethylethylene group, a methylethylmethylene group, a dimethylmethylene group, a diethylmethylene group, a methylethylethylene group, a dimethylethylene group, a diethylethylene group, a methyldiethylethylene group, a dimethylethylethylene group, a trimethylethylene group, a triethylethylene group, and a tetramethylethylene group; are preferably selected from a methylene group, an ethylene group, a methylmethylene group, an ethylmethylene group, a methylethylene group, an ethylethylene group, a methylethylmethylene group, a dimethylmethylene group, a diethylmethylene group, a methylethylethylene group, a dimethylethylene group, and a diethylethylene group; and are more preferably selected from a methylene group, an ethylene group, a methylmethylene group, an ethylmethylene group, a methylethylene group, an ethylethylene group, a methylethylmethylene group, a dimethylmethylene group, and a diethylmethylene group.

In the formula above, R^{2D} is preferably a benzene ring or naphthalene ring that may contain an alkyl group, and more preferably a benzene ring that may contain an alkyl group. The alkyl group that may be contained in R^{2D} is not particularly limited but is preferably a methyl group or an ethyl group. R^{2D} may be a divalent aromatic ring having no alkyl group. The aromatic ring of R^{2D} may contain 0 or more and 6 or less, 0 or more and 4 or less, 0 or more and 3 or less, 0 or more and 2 or less, or 0 or more and 1 or less alkyl group(s).

In the formula above, (R^{2X})ₙ means a divalent group having a structure in which n pieces of R^{2A}, R^{2B}, R^{2C}, and R^{2D} are bonded. Preferred aspects of R^{2A}, R^{2B}, R^{2C}, and R^{2D} in (R^{2X})ₙ are the same as those described above. (R^{2X})ₙ is not particularly limited, and examples thereof include the following structure:
- R^{2B}-
- R^{2B}-R^{2C}-
- R^{2B}-R^{2D}-
- R^{2D}-R^{2B}-R^{2D}-
- R^{2B}-R^{2A}-R^{2B}-
- R^{2B}-R^{2C}-R^{2B}-
- R^{2B}-R^{2D}-R^{2B}-

The number of R^{2B} contained in (R^{2X})ₙ may be 1 or more and 4 or less, preferably 1 or more and 3 or less, and more preferably 1 or 2. n is preferably 1 or greater and 5 or less, more preferably 1 or greater and 4 or less, and even more preferably 1 or greater and 3 or less.

The dihydroxy unit represented by Formula (5) above may be a unit that is derived from a dihydroxy compound having an alkylene group having 3 or more and 20 or less carbons as a main chain and having an alicyclic structure in a side chain of the alkylene group. Examples of the alicyclic structure in the side chain include a monocyclo ring, a bicyclo ring, a tricyclo ring, or a polycyclo ring, and the alicyclic structure may be a cycloalkyl group such as a cyclohexyl group or a monovalent group derived from a norbornane-based backbone. In this aspect, the number of carbons in the dihydroxy unit may be 5 or greater and 100 or less.

The curable resin of the present embodiment may only contain one type of dihydroxy unit or may contain two or more types of dihydroxy units.

The carbonate unit is preferably a structural unit derived from at least one selected from the group consisting of a dialkyl carbonate, a diaryl carbonate, and an alkyl aryl carbonate.

The curable resin of the present embodiment may contain an additional structural unit in addition to the dicarboxylic acid unit, the dihydroxy unit, and the carbonate unit described above. The additional structural unit is not particularly limited and is preferably a structural unit that does not negatively affect the dielectric properties of the curable resin. Examples of the additional structural unit include a structural unit derived from a dicarboxylic acid compound which does not correspond to Formula (4), a structural unit derived from a dihydroxy compound which does not correspond to Formula (5), and a monohydroxy compound having an ethylenic double bond.

Such a dicarboxylic acid compound is not particularly limited and examples thereof include a saturated aliphatic dicarboxylic acid, an aromatic dicarboxylic acid, and acid anhydrides thereof.

Examples of the saturated aliphatic dicarboxylic acid include cyclohexanedicarboxylic acid, cyclopentanedicarboxylic acid, adipic acid, succinic acid, sebacic acid, alkylsuccinic acid, cyclohexanediacetic acid, azelaic acid, malonic acid, dimethylmalonic acid, and oxalic acid.

Examples of the aromatic dicarboxylic acid include terephthalic acid, isophthalic acid, 1,4-naphthalenedicarboxylic acid, 2,6-naphthalenedicarboxylic acid, 2,7-naphthalenedicarboxylic acid, biphenyldicarboxylic acid, 5-tert-butyl-1,3-benzenedicarboxylic acid, 2,5-furandicarboxylic acid, and 2,5-thiophenedicarboxylic acid.

Furthermore, the dihydroxy compound described above is not particularly limited, and examples thereof include an aliphatic dihydroxy compound and an aromatic dihydroxy compound.

Examples of the aliphatic dihydroxy compound include ethylene glycol, 1,2-propanediol, 1,3-propanediol, 1,2-butanediol, 1,3-butanediol, 1,4-butanediol, 2,3-butanediol, 1,4-butenediol, 2-methyl-1,3-propanediol, 1,5-pentanediol, neopentyl glycol, 2-ethyl-2-methylpropane-1,3-diol, 2-butyl-2-ethylpropane-1,3-diol, 1,6-hexanediol, 3-methyl-1,5-pentanediol, 2-ethyl-1,3-hexanediol, 2,4-dimethyl-1,5-pentanediol, 2,2,4-trimethyl-1,3-pentanediol, 1,7-heptanediol, 1,8-octanediol, 1,9-nonanediol, and 1,10-decanediol.

Examples of the aromatic dihydroxy compound include hydroquinone, resorcin, 4,4'-dihydroxybiphenyl, xylylene glycol, 4,4'-dihydroxydiphenylbenzophenone, and bisphenols. Examples of the bisphenols include 2,2-bis(4-hydroxyphenyl)propane, 2,2-bis(3-methyl-4-hydroxyphenyl)propane, 2,2-bis(4-hydroxy-3,5-dimethylphenyl)propane, 2,2-bis(4-hydroxy-3,5-diethylphenyl)propane, 2,2-bis(4-hydroxy-(3-phenyl)phenyl)propane, 2,2-bis(4-hydroxy-(3,5-diphenyl)phenyl)propane, 2,2-bis(4-hydroxy-3,5-dibromophenyl)propane, bis(4-hydroxyphenyl)methane, 1,1-bis(4-hydroxyphenyl)ethane, 2,2-bis(4-hydroxyphenyl)butane, 2,2-bis(4-hydroxyphenyl)pentane, 1,1-bis(4-hydroxyphenyl)-1-phenylethane, bis(4-hydroxyphenyl)diphenylmethane, 1,1-bis(4-hydroxyphenyl)-2-ethylhexane, 1,1-bis(4-hydroxyphenyl)decane, bis(4-hydroxy-3-nitrophenyl)methane, 3,3-bis(4-hydroxyphenyl)pentane, 1,3-bis(2-(4-hydroxyphenyl)-2-propyl)benzene, 1,3-bis(2-(4-hydroxyphenyl)-2-propyl)benzene, 2,2-bis(4-hydroxyphenyl)hexafluoropropane, 1,1-bis(4-hydroxyphenyl)cyclohexane, bis(4-hydroxyphenyl)sulfone, 2,4'-dihydroxydiphenylsulfone, bis(4-hydroxyphenyl)sulfide, bis(4-hydroxy-3-methylphenyl)sulfide, bis(4-hydroxyphenyl)disulfide, 4,4'-dihydroxydiphenyl ether, 4,4'-dihydroxy-3,3'-dichlorodiphenyl ether, and 4,4'-(propane-2,2-diyl)bis(2-allylphenol).

Furthermore, examples of the aromatic dihydroxy compound include dihydroxy compounds each having an ether group bonded to an aromatic group, such as 2,2-bis(4-(2-hydroxyethoxy)phenyl)propane, 2,2-bis(4-(2-hydroxypropoxy)phenyl)propane, 1,3-bis(2-hydroxyethoxy)benzene, 4,4'-bis(2-hydroxyethoxy)biphenyl, and bis(4-(2-hydroxyethoxy)phenyl)sulfone; and dihydroxy compounds each having a fluorene ring, such as 9,9-bis(4-(2-hydroxyethoxy)phenyl)fluorene, 9,9-bis(4-hydroxyphenyl)fluorene, 9,9-bis(4-hydroxy-3-methylphenyl)fluorene, 9,9-bis(4-(2-hydroxypropoxy)phenyl)fluorene, 9,9-bis(4-(2-hydroxyethoxy)-3-methylphenyl)fluorene, 9,9-bis(4-(2-hydroxypropoxy)-3-methylphenyl)fluorene, 9,9-bis(4-(2-hydroxyethoxy)-3-isopropylphenyl)fluorene, 9,9-bis(4-(2-hydroxyethoxy)-3-isobutylphenyl)fluorene, 9,9-bis(4-(2-hydroxyethoxy)-3-tert-butylphenyl)fluorene, 9,9-bis(4-(2-hydroxyethoxy)-3-cyclohexylphenyl)fluorene, 9,9-bis(4-(2-hydroxyethoxy)-3-phenylphenyl)fluorene, 9,9-bis(4-(2-hydroxyethoxy)-3,5-dimethylphenyl)fluorene, 9,9-bis(4-(2-hydroxyethoxy)-3-tert-butyl-6-methylphenyl)fluorene, and 9,9-bis(4-(3-hydroxy-2,2-dimethylpropoxy)phenyl)fluorene.

Examples of the monohydroxy compound having an ethylenic double bond include hydroxy group-containing (meth)acrylic ester, and specific examples thereof include 2-hydroxyethyl (meth)acrylate, 3-hydroxypropyl (meth)acrylate, 4-hydroxybutyl (meth)acrylate, trimethylolpropane di(meth)acrylate, and pentaerythritol tri(meth)acrylate.

Furthermore, the curable resin may contain a structure derived from a silicone oil having a hydroxy group in a molecular structure, a structure derived from a silicone oil having a carboxy group in a molecular structure, and the like as partial structures.

A commercially available product can be used as a silicone oil having a hydroxy group in a molecular structure, and examples thereof include "KF-6001" (functional group equivalent: 900) and "KF-6002" (functional group equivalent: 1600) having hydroxy groups at both terminals, "X-22-1821" (functional group equivalent: 1470) (these are available from Shin-Etsu Chemical Co., Ltd.) and "BY-16-752A" (functional group equivalent: 1500) having phenolic hydroxyl groups at both terminals (this is available from Dow Corning Toray Co., Ltd.), "X-22-170BX" (functional group equivalent: 2800), "X-22-170DX" (functional group equivalent: 4670), "X-22-176DX" (functional group equivalent: 1600), and "X-22-176F" (functional group equivalent: 6300) having a hydroxyl group on one terminal (these are available from Shin-Etsu Chemical Co., Ltd.), "X-22-4039" (functional group equivalent: 970) and "X-22-4015" (functional group equivalent: 1870) having a hydroxyl group in a side chain (these are available from Shin-Etsu Chemical Co., Ltd.), "SF8427" (functional group equivalent: 930; available from Dow Corning Toray Co., Ltd.) and "X-22-4952" (functional group equivalent: 1100; available from Shin-Etsu Chemical Co., Ltd.) having hydroxyl groups in both terminal polyethers; and "FZ-2162" (functional group equivalent: 750) and "SH3773M" (functional group equivalent: 800) having a hydroxyl group in a side chain polyether (these are available from Dow Coming Toray Co., Ltd.).

Furthermore, a commercially available product can be used as the silicone oil having a carboxy group in a molecular structure, and examples thereof include "X-22-162C" having carboxy groups at both terminals (functional group equivalent: 2300), "X-22-3710" having a carboxy group at one terminal (functional group equivalent: 1450), and "X-22-3701E" having a carboxy group in a side chain (functional group equivalent: 4000) (these are available from Shin-Etsu Chemical Co., Ltd.).

By introducing the structural unit and/or a partial structure described above to the curable resin of the present embodiment, properties such as flexibility, thermal resistance, flame retardance, color tone, and solvent solubility tend be improved or imparted.

The terminal group in the curable resin of the present embodiment is not particularly limited and, for example, may be a carboxy group and/or a hydroxy group, and a structure in which a carboxy group and/or a hydroxy group is capped with a terminal blocking agent is preferred. According to the aspect containing a terminal blocking agent, the dielectric properties of the curable resin tend to be even better.

The terminal carboxy group-blocking agent is not particularly limited as long as the terminal carboxy group-blocking agent is a compound having a group that reacts with a carboxy group, and examples thereof include carbodiimide compounds such as monocarbodiimide and polycarbodiimide compounds, oxazoline compounds, and one terminal diol.

Examples of the terminal hydroxy group-blocking agent include diphenyl carbonate and monocarboxylic acid.

The curable resin of the present embodiment contains a dicarboxylic acid unit, a dihydroxy unit, and a carbonate unit. The order of bonding of these units is not particularly limited, and the dicarboxylic acid unit and the carbonate unit are preferably adjacent to the dihydroxy unit. Note that, in the curable resin, the oxygen atoms contained at both terminals of these units are shared by adjacent units. That is, for example, in a case where the dihydroxy unit and the dicarboxylic acid unit are adjacent, the structure forms the following ester bond:

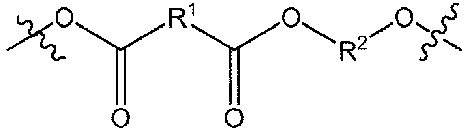

Furthermore, in a case where the dihydroxy unit and the carbonate unit are adjacent, the structure forms the following carbonate bond:

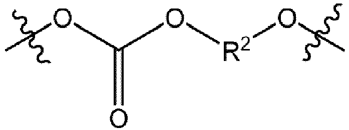

The curable resin of the present embodiment may be a random copolymer of the dicarboxylic acid unit, the dihydroxy unit, and the carbonate unit, may be a copolymer in which a copolymer of the carbonate unit and the dihydroxy unit is connected with the dicarboxylic acid unit, or may be a copolymer in which a copolymer of the dicarboxylic acid unit and the dihydroxy unit is connected with the carbonate unit.

In an aspect, the curable resin of the present embodiment contains a polyester moiety containing the dihydroxy unit and the dicarboxylic acid unit and containing no carbonate unit. In this aspect, the curable resin is preferably a polyester carbonate in which a plurality of polyester moieties formed of the dihydroxy unit and the dicarboxylic acid unit is connected to a plurality of the carbonate units. According to such an aspect, the dielectric properties of the curable resin tend to be further improved.

The molar ratio N_{COOH}/N_{OH} of the content N_{COOH} of the dicarboxylic acid unit to the content N_{OH} of the dihydroxy unit is preferably 0.010 or greater and less than 1.0, more preferably 0.025 or greater and 0.50 or less, even more preferably 0.050 or greater and 0.30 or less, and yet even more preferably 0.05 or greater and 0.20 or less. When the molar ratio N_{COOH}/N_{OH} is in the range described above, the proportion of the carbonate bond becomes greater, and the dielectric properties tend to be good. However, when the amount of N_{COOH} is too small, reactivity tends to be lower. The molar ratio N_{COOH}/N_{OH} can be measured by a nuclear magnetic resonance (NMR) spectrometer.

The molar ratio N_{OCOO}/(N_{OH}-N_{COOH}) of the content Nocoo of the carbonate unit to the contents N_{OH} and N_{COOH} of the dihydroxy unit is preferably greater than 1 and 1.5 or less, more preferably 1.001 or greater and 1.3 or less, even more preferably 1.005 or greater and 1.1 or less, and yet even more preferably 1.01 or greater and 1.0 or less. When the molar ratio N_{OCOO}/N_{OH} is in the range described above, the amount of terminal OH groups or COOH groups, which cause deterioration of the dielectric properties, of the resin becomes smaller, and the dielectric properties tend to be good. The molar ratio N_{OCOO}/N_{OH} can be measured by a nuclear magnetic resonance (NMR) spectrometer.

The molar ratio (N_{OH} + N_{COOH} + N_{OCOO})/Nₐₗₗ of the total content of the dihydroxy unit, the dicarboxylic acid unit, and the carbonate unit to all structural units Nₐₗₗ constituting the curable resin of the present embodiment is preferably 0.60 or greater, more preferably 0.70 or greater, even more preferably 0.80 or greater, and yet even more preferably 0.90 or greater. The upper limit value of the molar ratio (N_{OH} + N_{COOH} + N_{OCOO})/Nₐₗₗ is not particularly limited and, for example, may be 1.0, 0.98, or 0.96. When the molar ratio (N_{OH} + N_{COOH} + N_{OCOO})/Nₐₗₗ is 0.60 or greater, the dielectric properties, solvent solubility, bleedout resistance, and the like of the curable resin of the present embodiment tend to be further improved. The molar ratio (N_{OH} + N_{COOH} + N_{OCOO})/Nₐₗₗ can be measured by a nuclear magnetic resonance (NMR) spectrometer.

From the viewpoint of further improving the dielectric properties, solvent solubility, bleedout resistance, and the like of the curable resin, the proportion of the structural unit represented by Formula (4) is preferably 0.60 or greater, more preferably 0.70 or greater, even more preferably 0.80 or greater, and yet even more preferably 0.90 or greater, with respect to the amount of all the structural units derived from the dicarboxylic acid compound in the curable resin. The upper limit value of the proportion is not particularly limited and, for example, may be 1.0, 0.98, or 0.96.

From the similar viewpoint, the proportion of the structural unit represented by Formula (5) is preferably 0.60 or greater, more preferably 0.70 or greater, even more preferably 0.80 or greater, and yet even more preferably 0.90 or greater, with respect to the amount of all the structural units derived from the dihydroxy compound in the curable resin. The upper limit value of the proportion is not particularly limited and, for example, may be 1.0, 0.98, or 0.96.

The proportion of the structural unit represented by Formula (4) and the proportion of the structural unit represented by Formula (5) described above can be measured by a nuclear magnetic resonance (NMR) spectrometer.

Note that the content of the structural unit derived from each monomer can be controlled by adjusting a charged amount (used amount) of each monomer during production of the curable resin. In this case, a monomer that easily vaporizes and flows out from the system is preferably used in an amount that is greater than an amount of a monomer that is less likely to vaporize, taking the outflow from the system into consideration.

The number average molecular weight of the curable resin of the present embodiment is not particularly limited and is preferably 5.00 × 10² or greater and 3.00 × 10⁴ or less, more preferably 1.00 × 103 or greater and 2.00 × 104 or less, and even more preferably 3.00 × 103 or greater and 1.00 × 104 or less. When the number average molecular weight is 3.00 × 104 or less, solubility of the curable resin in a solvent tends to be even better. Thus, an aspect in which the number average molecular weight is 3.00 × 104 or less can be suitably used for use where infiltration into a filler (e.g., glass cloth) such as a copper-clad laminate is performed and use where dissolution into a solvent, like unsaturated polyester, is performed for use. Furthermore, when the number average molecular weight of the curable resin is 3.00 × 104 or less, occurrence of bleedout (phenomenon in which a resin does not react uniformly and a same composition aggregates to a level visually recognizable) tends to be more reliably prevented even when the curable resin is mixed with another curable resin, such as a maleimide resin, and cured.

On the other hand, the number average molecular weight of the curable resin is 5.00 × 102 or greater, the dihydroxy unit tends to be sufficiently incorporated into the resin, and the dielectric properties tend to further improve.

The number average molecular weight can be measured by gel permeation chromatography (GPLC).

The functional group equivalent of the terminal OH group in the curable resin of the present embodiment is not particularly limited and is preferably 500 g/eq or greater, more preferably 1000 g/eq or greater, and even more preferably 2000 g/eq or greater. When the functional group equivalent of the terminal OH group is in the range described above, the dielectric properties tend to be good. The functional group equivalent of the terminal OH group can be measured by Fourier transform infrared spectroscopy (FTIR) or by a nuclear magnetic resonance (NMR) spectrometer.

The curable resin of the present embodiment includes all aspects of the curable resin obtained by freely combining all aspects described above.

### [Resin Composition]

An embodiment of the present invention relates to a resin composition containing the curable resin of the present embodiment. The resin composition of the present embodiment may further contain another resin in addition to the curable resin of the present embodiment.

Examples of such another component that can be contained in the resin composition of the present embodiment include an epoxy resin, a cyanate compound, a maleimide compound, a BT resin, a compound having an ester structure derived from a phenol group and an aromatic carboxylic acid group, a modified silicone oil, a thermal stabilizer, an antioxidant, a curing agent, and a curing accelerator. One type of the component may be used alone, or two or more types of the components may be used in combination.

Examples of the epoxy resin include a phenolphenylaralkyl novolac-type epoxy resin, a phenolbiphenylaralkyl-type epoxy resin, a naphtholaralkyl-type epoxy resin, an anthraquinone-type epoxy resin, a polyoxynaphthylene-type epoxy resin, a bisphenol A-type epoxy resin, a bisphenol F-type epoxy resin, a phenol novolac epoxy resin, a cresol novolac-type epoxy resin, a bisphenol A novolac-type epoxy resin, a trifunctional phenol-type epoxy resin, a tetrafunctional phenol-type epoxy resin, a naphthalene-type epoxy resin, a biphenyl-type epoxy resin, an aralkyl novolac-type epoxy resin, an alicyclic epoxy resin, a polyol-type epoxy resin, glycidyl amine, glycidyl ester, a compound obtained by subjecting a double bond of butadiene or the like to epoxidation, a compound obtained by a hydroxyl group-containing silicone resin and epichlorohydrin, and halides of these. One of these may be used alone, or two or more of these may be used in combination.

Examples of the cyanate compound include a naphtholaralkyl-type cyanate compound, a novolac-type cyanate, a phenolbiphenylaralkyl-type cyanate compound, bis(3,5-dimethyl-4-cyanatophenyl)methane, bis(4-cyanatophenyl)methane, 1,3-dicyanatobenzene, 1,4-dicyanatobenzene, 1,3,5-tricyanatobenzene, 1,3-dicyanatonaphthalene, 1,4-dicyanatonaphthalene, 1,6-dicyanatonaphthalene, 1,8-dicyanatonaphthalene, 2,6-dicyanatonaphthalene, 2,7-dicyanatonaphthalene, 1,3,6-tricyanatonaphthalene, 4,4'-dicyanatobiphenyl, bis(4-cyanatophenyl)ether, bis(4-cyanatophenyl)thioether, bis(4-cyanatophenyl)sulfone, 2,2-bis(4-cyanatophenyl)propane, polymethylene polyphenyl polyisocyanate, m-tetramethylxylene diisocyanate, hydrogenated xylylene diisocyanate (1,3-bis(isocyanatomethyl)cyclohexane), isophorone diisocyanate, norbornene diisocyanate, dicyclohexylmethane diisocyanate, hydrogenated methylene bisphenylene diisocyanate, 1,4-cyclohexane diisocyanate, 1,6-hexamethylene diisocyanate, trimethylene diisocyanate, and a trifunctional isocyanate having an isocyanurate ring obtained by subjecting a bifunctional isocyanate compound to trimerization. One of these may be used alone, or two or more of these may be used in combination.

Examples of the maleimide compound include N-phenylmaleimide, N-hydroxyphenylmaleimide, bis(4-maleimidophenyl)methane, 2,2-bis{4-(4-maleimidophenoxy)-phenyl}propane, bis(3,5-dimethyl-4-maleimidophenyl)methane, bis(3-ethyl-5-methyl-4-maleimidophenyl)methane, bis(3,5-diethyl-4-maleimidophenyl)methane, prepolymers of these maleimide compounds, and prepolymers of maleimide compounds and amine compounds. One of these may be used alone, or two or more of these may be used in combination.

The BT resin is a resin obtained by subjecting a cyanate compound and a maleimide compound to heating and mixing in a solventless manner or by dissolving in an organic solvent, such as methyl ethyl ketone, N-methylpyrrolidone, dimethylformamide, dimethylacetamide, toluene, and xylene, and to prepolymerization. Note that, as the cyanate compound and the maleimide compound, those described above can be used. One of these may be used alone, or two or more of these may be used in combination.

Examples of the compound having an ester structure derived from a phenol group and an aromatic carboxylic acid group include an active ester resin (I) having as a reaction raw material a compound selected from the group consisting of a compound (a1) containing one phenolic hydroxyl group, a compound (a2) containing two or more phenolic hydroxyl groups, and an aromatic polycarboxylic acid or acid halide thereof (a3); and an active ester resin (II) having as a reaction raw material a compound selected from the group consisting of a compound (b 1) having two or more phenolic hydroxyl groups, an aromatic monocarboxylic acid or acid halide thereof (b2) and an aromatic polycarboxylic acid of acid halide thereof (b3). For specific examples of these compounds, reference can be made to WO 2020/003824. One of these may be used alone, or two or more of these may be used in combination.

Examples of the modified silicone oil include a modified silicone oil that has a chain-like siloxane backbone and that has a group other than hydrogen or a hydrocarbon group in a molecular structure. Examples of the modification group include an epoxy group, an amino group, a hydroxyl group, a methacryl group, a mercapto group, a carboxy group, an alkoxy group, and a silanol group. One of these may be used alone, or two or more of these may be used in combination.

Examples of the thermal stabilizer include phosphorous acid, phosphoric acid, phosphonous acid, phosphonic acid, and esters of these. Specific examples thereof include triphenyl phosphite, tris(nonylphenyl) phosphite, tris(2,4-di-tert-butylphenyl) phosphite, tridecyl phosphite, trioctyl phosphite, trioctadecyl phosphite, didecyl monophenyl phosphite, dioctyl monophenyl phosphite, diisopropyl monophenyl phosphite, monobutyl diphenyl phosphite, monodecyl diphenyl phosphite, monooctyl diphenyl phosphite, bis(2,6-di-tert-butyl-4-methylphenyl)pentaerythritol diphosphite, 2,2-methylene-bis(4,6-di-tert-butylphenyl)octyl phosphite, bis(nonylphenyl)pentaerythritol diphosphite, bis(2,4-di-tert-butylphenyl)pentaerythritol diphosphite, distearylpentaerythritol diphosphite, tributyl phosphate, triethyl phosphate, trimethyl phosphate, triphenyl phosphate, diphenylmonoorthoxenyl phosphate, dibutyl phosphate, dioctyl phosphate, diisopropyl phosphate, tetrakis-(2,4-di-tert-butylphenyl) 4,4'-biphenylenediphosphonite, dimethyl benzenephosphonate, diethyl benzenephosphonate, and dipropyl benzenephosphonate. One of these may be used alone, or two or more of these may be used in combination.

Examples of the antioxidant include pentaerythritol tetrakis(3-mercaptopropionate), pentaerythritol tetrakis(3-laurylthiopropionate), glycerol-3-stearylthiopropionate, triethylene glycol-bis[3-(3-tert-butyl-5-methyl-4-hydroxyphenyl)propionate], 1,6-hexanediol-bis[3-(3,5-di-tert-butyl-4-hydroxyphenyl)propionate], pentaerythritol-tetrakis[3-(3,5-di-tert-butyl-4-hydroxyphenyl)propionate], octadecyl-3-(3,5-di-tert-butyl-4-hydroxyphenyl)propionate, 1,3,5-trimethyl-2,4,6-tris(3,5-di-tert-butyl-4-hydroxybenzyl)benzene, N,N-hexamethylene bis(3,5-di-tert-butyl-4-hydroxy-hydrocinnamide), 3,5-di-tert-butyl-4-hydroxy-benzylphosphonate-diethyl ester, tris(3,5-di-tert-butyl-4-hydroxybenzyl)isocyanurate, tetrakis(2,4-di-tert-butylphenyl) 4,4'-biphenylenediphosphinate, and 3,9-bis {1,1-dimethyl-2-[(3-(3-tert-butyl-4-hydroxy-5-methylphenyl)propionyloxy]ethyl}-2,4,8,10-tetraoxaspiro(5,5)undecane. One of these may be used alone, or two or more of these may be used in combination.

Examples of the curing agent include a polyfunctional phenol compound such as phenol novolac, cresol novolac, an amino triazine novolac resin; an amine compound such as dicyandiamide, diaminodiphenylmethane, and diaminodiphenylsulfone; and an acid anhydride such as phthalic anhydride, pyromellitic anhydride, and maleic anhydride.

Examples of the curing accelerator include organic metal salts and organic metal complexes such as zinc naphthenate, cobalt naphthenate, tin octylate, cobalt octylate, cobalt(II) bisacetylacetonate, cobalt(III) trisacetylacetonate, zinc(II) acetylacetonate, and iron(III) acetylacetonate, imidazoles and derivatives thereof, organophosphorus-based compounds, secondary amines, tertiary amines, and quaternary ammonium salts.

One of these may be used alone, or two or more of these may be used in combination.

The resin composition of the present embodiment may contain a component that cures together with the curable resin of the present embodiment by reacting with the curable resin of the present embodiment, among the components described above. Examples of such a component include (meth)acrylate, isocyanurate, a maleimide compound, a compound having a vinyl group, and a compound having an aryl group.

The resin composition may further contain an initiator to initiate curing. Examples of the initiator include an organic peroxide-based initiator that initiates curing by heating, and a UV initiator that initiates curing by photoirradiation.

Examples of the organic peroxide-based initiator include ketone peroxides such as methyl ethyl ketone peroxide and acetyl acetone peroxide; diacyl peroxides such as benzoyl peroxide; peroxy esters such as t-butyl peroxybenzoate; hydroperoxides such as cumene hydroperoxide; and dialkyl peroxides such as dicumyl peroxide.

Examples of the UV initiator include benzophenones such as benzophenone, benzil, and methyl o-benzoylbenzoate; benzoin ethers such as benzoin alkyl ether; acetophenone such as benzil dimethylketal, 2,2-diethoxyacetophenone, 2-hydroxy-2-methylpropiophenone, 4-isopropyl-2-hydroxy-2-methylpropiophenone, and 1,1-dichloroacetophenone; and thioxanthone such as 2-chlorothioxanthone, 2-methylthioxanthone, and 2-isopropylthioxanthone.

The resin composition may further contain a crosslinking agent other than those described above. However, the curable resin of the present embodiment can be cured alone without using a crosslinking agent because of having an ethylenic double bond and/or an acetylene triple bond. Thus, the resin composition of the present embodiment may contain no crosslinking agent.

The content of the curable resin of the present embodiment contained in the resin composition may be, for example, 1.0 part by mass or greater with respect to 100 parts by mass of the resin component (a resin and a component curing together with the resin, synonymous with solid component).

For example, in a case where the curable resin of the present embodiment is added in a resin composition as a compatibilizer, the content of the curable resin of the present embodiment may be, for example, 1.0 part by mass or greater and 10 parts by mass or less, or 3.0 parts by mass or greater and 5.0 parts by mass or less, with respect to 100 parts by mass of the resin component.

Alternatively, the content of the curable resin of the present embodiment contained in the resin composition may be, for example, 10 parts by mass or greater, 20 parts by mass or greater, 30 parts by mass or greater, 50 parts by mass or greater, 70 parts by mass or greater, 80 parts by mass or greater, 90 parts by mass or greater, or 95 parts by mass or greater, with respect to 100 parts by mass of the resin component. When the content of the curable resin of the present embodiment is in the range described above, a resin composition having even better dielectric properties tends to be obtained. Furthermore, a cured product of the resin composition has low yellowness, that is, tends to have a good color tone.

The upper limit value of the content of the curable resin of the present embodiment contained in the resin composition is not particularly limited and may be 100 parts by mass, 99 parts by mass, 95 parts by mass, 90 parts by mass, or 80 parts by mass, with respect to 100 parts by mass of the resin component.

Note that the content of the component other than the curable resin of the present embodiment contained in the resin composition may be appropriately adjusted in a range that makes the content of the curable resin of the present embodiment in the resin composition to be in the range described above.

The resin composition may further contain a filler such as a reinforcing substrate and an inorganic filler.

The inorganic filler is not particularly limited as long as the inorganic filler is an inorganic filler typically used in this field. Specifically, examples of the inorganic filler include silica, such as natural silica, fused silica, amorphous silica, and hollow silica; metal hydroxides, such as aluminum hydroxide, an aluminum hydroxide heat-treated product (a product obtained by heating aluminum hydroxide to reduce a part of the crystalline water), magnesium hydroxide, and boehmite; nitride compounds, such as aluminum nitride and boron nitride; molybdenum compounds, such as molybdenum oxide and zinc molybdate; zinc borate, zinc stannate, alumina, clay, kaolin, talc, calcined clay, calcined kaolin, calcined talc, mica, glass short fibers (including glass fine powders of E glass, D glass, and the like), hollow glass, spherical glass, titanium oxide, silicone rubbers, and silicone composite powders.

Examples of the reinforcing substrate include paper, glass cloth, glass nonwoven fabric, aramid paper, aramid fabric, glass mat, and glass roving cloth.

One type of the filler may be used alone, or two or more types of the fillers may be used in combination.

The content of the filler contained in the resin composition is not particularly limited and is, for example, from 1 to 2000 parts by mass with respect to 100 parts by mass of the resin. The content of the filler can be appropriately changed based on the use of the resin composition.

The resin composition may contain a silane coupling agent and a wet dispersant in addition to the filler. When these components are contained, dispersibility of the filler, especially inorganic filler, tends to improve, and adhesive strength between the resin and the filler tends to improve.

The silane coupling agent is not particularly limited and can be any silane coupling agent commonly used for surface treatment of inorganic materials. Specific examples thereof include aminosilane-based silane coupling agents, such as γ-aminopropyltriethoxysilane and N-β-(aminoethyl)-γ-aminopropyltrimethoxysilane; epoxysilane-based silane coupling agents such as γ-glycidoxypropyltrimethoxysilane; vinylsilane-based silane coupling agents, such as γ-methacryloxypropyltrimethoxysilane; cationic silane-based silane coupling agents, such as N-β-(N-vinylbenzylaminoethyl)-γ-aminopropyltrimethoxysilane hydrochloride; phenylsilane-based silane coupling agents; styrylsilane-based silane coupling agents, such as p-styryltrimethoxysilane, p-styryltriethoxysilane, p-styrylmethyldimethoxysilane, p-styrylmethyldiethoxysilane, and N-(vinylbenzyl)-2-aminoethyl-3-aminopropyltrimethoxysilane hydrochloride.

The wet dispersant is not particularly limited as long as the wet dispersant is a dispersion stabilizer that is used for paints. Specific examples include wet dispersants, such as Disperbyk-110, 111, 180, 161, BYK-W996, W9010, and W903 available from BYK Japan KK.

For these silane coupling agents and wet dispersants, one type may be used alone, or two or more types may be used in combination.

Furthermore, the resin composition according to the present embodiment may contain a solvent as necessary. When the resin composition contains an organic solvent, the viscosity at the time of preparation of the resin composition tends to decrease, and handleability tends to improve. The solvent is not particularly limited as long as the solvent is a solvent that can dissolve at least one component in the resin composition. Specific examples of the solvent include ketones, such as acetone, methyl ethyl ketone, and methyl cellosolve; aromatic hydrocarbons, such as toluene and xylene; amides, such as dimethylformamide; and propylene glycol methyl ether and its acetate. One type of the solvent may be used alone, or two or more types of the solvents may be used in combination.

### [Cured Product]

An embodiment of the present invention relates to a cured product of the curable resin of the present embodiment and a cured product of the resin composition of the present embodiment. Because the cured product of the present embodiment is a cured product containing the curable resin of the present embodiment, excellent dielectric properties are achieved. Furthermore, the cured product of the present embodiment tends to have a good color tone.

A method of curing the curable resin or the resin composition of the present embodiment is not particularly limited and may be appropriately selected based on the type of the resin. Examples of the curing method include thermosetting and photocuring.

In a case where the resin composition is cured, preferably, the resin composition is once dissolved in a solvent to uniformly mix components, and then a dried material thereof is cured.

### [Application]

Examples of the use of the curable resin, the resin composition, and the cured products thereof of the present embodiment include use for an electronic material. Specific examples thereof include an electronic member, a semiconductor sealing material, a mold resin, a rigid substrate, a prepreg, a laminate, a copper foil including a resin, a circuit board, an underfill material, and a build-up film. In addition, as an additive such as an unsaturated polyester or an epoxy resin or a single application, use as a fiber-reinforced composite material such as a carbon fiber-reinforced plastic or a glass fiber-reinforced plastic can be considered.

The fiber-reinforced composite material contains the resin composition of the present embodiment and a reinforcing fiber and can produce a fiber-reinforced molded article by being cured. The reinforcing fiber is not particularly limited, and examples thereof include glass fibers, carbon fibers, boron fibers, and aramid fibers.

The semiconductor sealing material contains the resin composition of the present embodiment and an inorganic filler and is used for production of a semiconductor device. As the inorganic filler, those described above can be used.

The prepreg contains a substrate and a resin composition infiltrating into or applied to the substrate. The method for producing the prepreg can be performed according to a common method and is not particularly limited. For example, the production can be performed by subjecting a substrate to impregnation or application of the resin composition and then subjecting the resin composition to semi-cure (to B-stage) by drying in a dryer at 100 to 200°C for 1 to 30 minutes.

The substrate is not particularly limited, and a known substrate used in various printed wiring board materials can be used by appropriate selection according to the intended use or performance. Specific examples of the fiber constituting the substrate include, but not particularly limited to, glass fibers, such as those of E glass, D glass, S glass, Q glass, spherical glass, NE glass, L glass, and T glass; inorganic fibers other than those of glass, such as those of quartz; and organic fibers, such as those of wholly aromatic polyamide including polyparaphenylene terephthalamide (Kevlar (trade name) available from Du Pont Co., Ltd.) and copolyparaphenylene/3,4'oxydiphenylene terephthalamide (Technola (trade name) available from Teijin Techno Products Ltd.), polyester including 2,6-hydroxynaphthoic acid-parahydroxy benzoic acid (Vectran (trade name) available from Kuraray Co., Ltd.) and Zxion (trade name, available from KB Seiren Ltd.), polyparaphenylene benzoxazole (Zylon (trade name) available from Toyobo Co., Ltd.), and polyimide. These substrates may be used alone or in combination of two or more.

The laminate is a multilayered body including at least a prepreg. The laminate can be obtained by, for example, combining a prepreg and another layer to multilayer-mold. Examples of such another layer is not particularly limited, and examples thereof include a circuit board for an inner layer, which is separately prepared.

The circuit board includes the laminate, and a metal foil provided on one face or both faces of the laminate. The circuit board is, for example, a copper foil-clad laminate obtained by layering the prepreg and a copper foil and curing. The copper foil used is any copper foil used in printed wiring board materials but is preferably a copper foil, such as a rolled copper foil and an electrolytic copper foil.

The build-up film includes a cured product of the resin composition and a substrate film. The term "build-up" means preparing a printed circuit board having a multilayered structure by laminating a prepreg or a resin sheet as well as by repeating boring processing and wiring formation for layers.

As further effects of the present embodiment, for example, low thermal expansion, crack prevention, good color tone, solvent solubility, and separation prevention between resins during curing are expected.

### Examples

Hereinafter, the present invention will be described in further detail with reference to Examples and Comparative Examples, but the technical scope of the present invention is not limited to these examples.

### (Measurement of Number Average Molecular Weight of Curable Resin)

A curable resin was dissolved in tetrahydrofuran in a manner that the resin concentration became 0.2 mass% and was measured by gel permeation chromatography (GPC). Based on a calibration curve prepared by using standard polystyrene, the number average molecular weight of each curable resin was calculated. GPC was used with the column TSKgel SuperHM-M, available from Tosoh Corporation, and measurement was performed at a column temperature of 40°C. Tetrahydrofuran was flown at a flow rate of 0.6 mL/min as an eluent, and measurement was performed by an RI detector.

### (Measurement of Dielectric Loss Tangent)

A rod-shaped sample of a cured product of the resin composition of each Examples and Comparative Examples described below was prepared, and the dielectric loss tangent at 10 GHz was measured by using a cavity resonator perturbation method (Agilent 8722ES, available from Agilent Technologies, Inc.).

Abbreviations in the following Examples and Comparative Examples refer to the following compounds:
D-NDM: (approximately 1: 1 mixture of decahydro-1,4:5,8-dimethanonaphthalene-2,6(7)-dimethanol represented by Formulas (8) and (9) below) 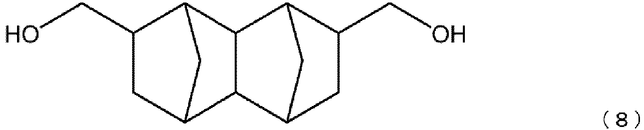 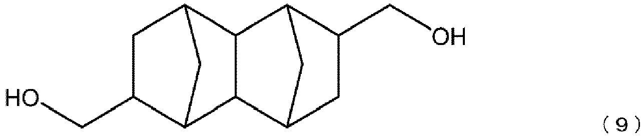
DPC: Diphenyl carbonate
TBT: Tetra-n-butyl titanate
DCP: Tricyclodecanol acrylate (available from Shin-Nakamura Chemical Co., Ltd.)

### Example 1

### (Polymerization of Curable Resin A)

In a 500 mL separable flask, 175 g of D-NDM, 7.7 g of maleic anhydride, and 0.015 g of TBT were charged and agitated under a nitrogen flow, heated gradually to 200°C, and maintained until no distilled water was generated. Thereafter, the pressure was gradually reduced to 13 kPa and maintained for 30 minutes, and the temperature was cooled to room temperature. Thereafter, 163 g of DPC was added. The temperature was gradually increased and the pressure was gradually reduced to perform polymerization finally at 230°C and 0.1 kPa or less, and thus a curable resin A was obtained. The number average molecular weight of the curable resin A was 5000.

### (Purification of Curable Resin A)

The curable resin A was dissolved in toluene in a manner that the weight percent became 20 wt%. In a 2 L separating funnel, 500 mL of 5 wt% sodium carbonate aqueous solution and 500 mL of the resin solution were charged and agitated 100 times, and then the mixture was allowed to stand until the solution was separated. After the standing, an emulsion layer and an aqueous layer were extracted. Thereafter, the same procedure was repeated twice with a 5 wt% sodium carbonate aqueous solution and seven times with purified water, and then a toluene resin solution was extracted. Thus, the curable resin A was purified.

### Comparative Example 1

### (Polymerization of Curable Resin B)

In a 500 mL separable flask, 175 g of D-NDM, 152 g of DPC, and 0.015 g of TBT were charged and agitated under a nitrogen flow. The temperature was gradually increased and the pressure was gradually reduced to perform polymerization finally at 230°C and 0.1 kPa or less. After the cooling down to room temperature, 7.7 g of maleic anhydride was added, and the temperature was increased to 200°C and maintained until no water was generated. Thereafter, the pressure was gradually reduced to 13 kPa and maintained for 30 minutes to perform polymerization. Thus, a curable resin B was obtained. The number average molecular weight of the curable resin B was 5000.

### (Purification of Curable Resin B)

The curable resin B was dissolved in toluene in a manner that the weight percent became 20 wt%. In a 2 L separating funnel, 500 mL of 5 wt% sodium carbonate aqueous solution and 500 mL of a resin solution were charged and agitated 100 times, and then the mixture was allowed to stand until the solution was separated; however, even after one week, the liquid was not separated. Thus, the curable resin B could not be purified.

**[Table 1]**

| | Example 1 | Comparative Example 1 |
|---|---|---|
| Feasibility of Purification | ○ | × |

### Example 2

5.6 g of the curable resin A, 1.9 g of DCP, and 0.075 g of Perbutyl P (available from NOF Corporation) were weighed and dissolved in toluene in a manner that the weight percent became 20 wt%. Thereafter, the mixture was put in a vacuum drier and dried at room temperature for 48 hours and at 60°C for 3 hours to remove the toluene. The resin after the toluene removal was charged in a mold having a thickness of 1 mm, sandwiched by Fluon ETFE film (available from AGC Inc.) at the top and an SUS sheet at the bottom of the resin, and placed in a vacuum pressing machine that had been heated to 200°C. After the pressure was reduced to 10⁻² kPa, pressing was performed by gradually applying pressure to 0.6 MPa. The resin was taken out after 90 minutes of heating and then gradually cooled. After the gradual cooling, the resin was taken out from the mold. The taken-out resin was cut into a width of 0.8 mm to prepare a rod-shaped sample. The cut sample was dried in a vacuum drier at 70°C for one day, and then the dielectric loss tangent was measured. The results are presented in Table 2.

### Comparative Example 2

The dielectric loss tangent was measured by the same method as in Example 2 except for using the curable resin B in place of the curable resin A. The results are presented in Table 2.

**[Table 2]**

| | Example 2 | Comparative Example 2 |
|---|---|---|
| Dielectric constant (Dk) | 2.4 | 2.5 |
| Dielectric loss tangent (Df) | 0.006 | 0.008 |

## Claims

1. A method for producing a curable resin, the method comprising:
a step (A) of reacting a compound represented by Formula (2) and a compound represented by Formula (1) and/or a compound represented by Formula (1') in a molar equivalent smaller than the molar equivalent of the compound represented by Formula (2) by heating at normal pressure; and
a step (B) of reacting a reaction product obtained by the step (A) and a compound represented by Formula (3) by heating at normal pressure: 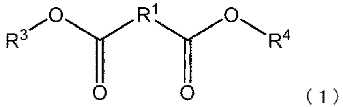 where in Formula (1), R¹ is a divalent group having an ethylenic double bond and/or an acetylene triple bond, and R³ and R⁴ are each independently a hydrogen atom or a monovalent hydrocarbon group having from 1 to 7 carbons; 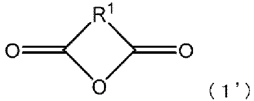 where in Formula (1'), R¹ is synonymous with R¹ in Formula (1); 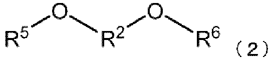 where in Formula (2), R² is any divalent group, and R⁵ and R⁶ are each independently a hydrogen atom or a monovalent hydrocarbon group having from 1 to 7 carbons; and 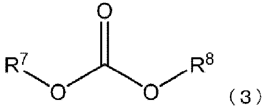 where in Formula (3), R⁷ and R⁸ are each independently any substituent.

2. The method for producing a curable resin according to claim 1, wherein, in the step (A), a used amount of the compound represented by Formula (2) in terms of molar ratio with respect to a total used amount of the compound represented by Formula (1) and the compound represented by Formula (1') is 2 or greater and 100 or less.

3. The method for producing a curable resin according to claim 1, wherein, after the compound represented by Formula (2) and the compound represented by Formula (1) and/or the compound represented by Formula (1') are reacted by heating at normal pressure, the step (A) further comprises reacting under reduced pressure.

4. The method for producing a curable resin according to claim 1, wherein a pressure reduction condition when applying reduced pressure in the step (A) is 100 kPa or less.

5. The method for producing a curable resin according to claim 1, wherein a reaction temperature in the step (A) is from 80 to 290°C.

6. The method for producing a curable resin according to claim 1, wherein, after the reaction product obtained by the step (A) and the compound represented by Formula (3) are reacted by heating at normal pressure, the step (B) further comprises reacting under reduced pressure.

7. The method for producing a curable resin according to claim 1, wherein a pressure reduction condition when applying reduced pressure in the step (B) is 10 kPa or less.

8. The method for producing a curable resin according to claim 1, wherein, in the step (B), a used amount of the compound represented by Formula (3) is an amount greater than a number of moles obtained by subtracting a total used amount of the compound represented by Formula (1) and/or the compound represented by Formula (1') from a used amount of the compound represented by Formula (2).

9. The method for producing a curable resin according to claim 1, wherein a reaction temperature in the step (B) is from 100 to 290°C.

10. The method for producing a curable resin according to claim 1, wherein the compound represented by Formula (1) and the compound represented by Formula (1') are at least one selected from the group consisting of fumaric acid, maleic acid, and maleic anhydride.

11. The method for producing a curable resin according to claim 1, wherein R² in Formula (2) is a divalent group having an alicyclic structure in a main chain or a side chain.

12. The method for producing a curable resin according to claim 1, wherein the compound represented by Formula (2) comprises at least one selected from the group consisting of a norbomane-based backbone and a cyclohexane-based backbone.

13. The method for producing a curable resin according to claim 1, wherein the compound represented by Formula (3) is at least one selected from the group consisting of a dialkyl carbonate, a diaryl carbonate, and an alkyl aryl carbonate.

14. The method for producing a curable resin according to claim 1, wherein a functional group equivalent of a terminal OH group of the curable resin is 500 g/eq or greater.

15. The method for producing a curable resin according to claim 1, wherein a number average molecular weight of the curable resin is 5.00 × 10² or greater and 3.00 × 10⁴ or less.

16. A curable resin produced by the production method according to any one of claims 1 to 15.

17. A resin composition, comprising the curable resin according to claim 16.

18. A cured product of the curable resin according to claim 16 or the resin composition according to claim 17.

19. The resin composition according to claim 17, which is for an electronic material.

20. An electronic member, comprising the resin composition according to claim 17.

21. A fiber-reinforced composite material, comprising the resin composition according to claim 17 and a reinforcing fiber.

22. A fiber-reinforced molded article, which is a cured product of the fiber-reinforced composite material according to claim 21.

23. A semiconductor sealing material, comprising the resin composition according to claim 17 and an inorganic filler.

24. A semiconductor device, comprising a cured product of the semiconductor sealing material according to claim 23.

25. A prepreg, comprising a substrate, and the resin composition according to claim 17 with which the substrate is impregnated or coated.

26. A laminate, comprising the prepreg according to claim 25.

27. A circuit board, comprising the laminate according to claim 26, and a metal foil provided on one face or both faces of the laminate.

28. A build-up film, comprising a cured product of the resin composition according to claim 17 and a substrate film.
